# EUROPÄISCHE PATENTSCHRIFT

(11) **EP 3 599 806 B1**
(45) Veröffentlichungstag und Bekanntmachung des Hinweises auf die Patenterteilung: **30.12.2020**
(21) Anmeldenummer: 19183152.8
(22) Anmeldetag: 28.06.2019
(51) Int. Cl.: H05K 7/20, H01L 23/13, H01L 23/40

(54) **VERFAHREN ZUM MONTIEREN EINES ELEKTRISCHEN BAUTEILS AUF EINEM SOCKELTEIL**
METHOD FOR MOUNTING AN ELECTRICAL COMPONENT ON A BASE PART
PROCÉDÉ DE MONTAGE D'UN COMPOSANT ÉLECTRIQUE SUR UNE PARTIE DE SOCLE

(30) Priorität: 23.07.2018 DE 102018117695
(43) Veröffentlichungstag der Anmeldung: 29.01.2020
(73) Patentinhaber: SICK AG, 79183 Waldkirch (DE)
(72) Erfinder: Schneider, Florian, 79276 Reute (DE); Deblitz, Bernd, 77716 Haslach (DE)

(56) Entgegenhaltungen:
- DE-A1-102006 037 747
- DE-A1-102007 049 035
- DE-U1- 8 711 779
- US-A1- 2005 047 092
- US-A1- 2013 003 316
- US-A1- 2014 133 093

## Beschreibung

Die Erfindung betrifft ein Verfahren zum Montieren eines elektrischen Bauteils auf einem Sockelteil nach dem Oberbegriff von Anspruch 1.

Die thermische Anbindung von elektrischen Bauteilen ist ein wichtiger Aspekt, der beim Design und bei der Herstellung eines Sensors beachtet werden muss, um dessen Funktion zu gewährleisten. Dabei werden nach Möglichkeit die elektrischen Verbraucher direkt mit dem Sensorgehäuse verbunden, um die Eigenerwärmung des Gerätes so gering wie möglich zu halten. Bei erhöhter Gerätetemperatur drohen Einbußen der Effizienz von optoelektrischen Bauteilen wie Lasern oder LEDs, eine Verschlechterung des Signal-Rausch-Verhältnisses bei Lichtempfängern und Bildsensoren sowie eine verkürzte Lebensdauer. Außerdem müssen die elektrischen Bauteile im spezifizierten Temperaturbereich betrieben werden.

Bei der Montage beziehungsweise dem Zusammenbauen treten mechanische Toleranzen auf. Damit besteht die zusätzliche Herausforderung, dass die Temperaturanbindung der elektrischen Bauteile durch solche Toleranzen möglichst nicht beeinträchtigt werden sollte.

Eine herkömmliche Möglichkeit, mit solchen Toleranzen umzugehen, ist eine individuelle Behandlung von Gerät zu Gerät bei der Montage. Dazu werden die Komponenten zunächst ohne Wärmeübergangsmaterial zusammengebaut, und der Abstand zwischen elektrischem Bauteil und Wärmesenke wird vermessen. Dann werden die Komponenten wieder auseinandergebaut, über ein anhand des gemessenen Abstands ausgewähltes Kupferblech werden die großen Toleranzen ausgeglichen, und eine dünne Wärmeleitfolie wird ergänzt, ehe die Bauteile dann verschraubt werden. Die Kupferbleche liegen in gestaffelter Dicke vor. Ein solcher individueller Prozess ist sehr aufwändig und zudem fehleranfällig.

Eine andere Möglichkeit, um mechanische Toleranzen bei guter Wärmeanbindung auszugleichen, sind Wärmeleitrohre (Heatpipes), die aber ebenfalls mit relativ hohen Kosten verbunden sind.

Die US 2017/0363371 A1 offenbart ein selbstausrichtendes Kühlmodul mit zwei Keilen, die mit einem festen thermischen Anbindungsmaterial dazwischen aufeinanderliegen. Eine Feder drückt seitlich gegen einen der Keile, dadurch verklemmen sich die beiden Keile unter Ausgleich von Toleranzen zwischen einer oben befindlichen elektronischen Komponente und einer unten angeordneten Wärmesenke. Das hat aber einige Nachteile: Durch die indirekte seitliche Krafteinwirkung mittels der Feder ist der thermische Übergang zwischen den Keilen beeinträchtigt, und über den Hebel der Keile wird die Wärmesenke ständig mechanisch belastet. Wegen der beiden Keile muss der Temperaturfluss von der elektronischen Komponente bis zur Wärmesenke mehrere Schnittstellen überwinden. Es ist eine langzeitstabile Feder erforderlich, die über die ganze Lebensdauer eine definierte Kraft ausübt.

Die DE 10 2007 049 0035 A1 offenbart eine Chipkühlvorrichtung mit einem Keilelement zwischen einer zu kühlenden Oberfläche des Chips und einer Oberfläche des Kühlkörpers. Der Kühlkörper selbst weist eine schräge Kühlkörperoberfläche auf, die mit der Oberfläche des Chips einen keilförmigen Zwischenraum bildet. Darin wird das Keilelement mit einer Blattfeder gehalten, die einen ausreichenden Druck auf das Keilelement ausübt, um dessen Lockerung zu verhindern.

Aus der DE 10 2006 037 747 A1 ist eine Anordnung zur Kühlung eines elektrischen Bauelements bekannt. Hier wird in einer Ausführungsform ebenfalls ein Keilelement zwischen Kühleinrichtung und einen Träger des elektrischen Bauelements geschoben, und zwar von einem Bimetallstreifen, der die gegenseitige Auflagefläche temperaturabhängig vergrößert oder verkleinert.

Die US 2014/0133093 A1 befasst sich mit einem Kühlsystem für eine Elektronikkomponente. Sie wird in eine keilförmige Hülle gepackt, die in zu der Keilform komplementäre Wärmeleitkeile eingesetzt wird. Je nach Ausführungsform wird die Hülle in dieser Position durch die Schwerkraft oder einen von der Basis des Keils her schließenden Hebel gehalten.

In der US 2005/0047092 A1 wird ein Verfahren zum Montieren einer keilförmigen thermischen Verbindung vorgestellt, bei dem die Keile zu Veränderung der Gesamthöhe gegeneinander verschoben werden.

Die DE 87 11 779 U1 beschreibt einen Wärmeleiter für Bauelemente der elektrischen Nachrichtentechnik. Hier werden zwei entgegengerichtete Keile zwischen Kühlkörper und Bauelement gegeneinander verschoben.

Aus der US 2013/0003316 A1 ist ein System zum wieder lösbaren Anbringen einer Leiterkarte an einer Kühlplatte eines Gehäuses bekannt. Die Verbindung nutzt eine Basis und einen Schließkeil (""locking wedge") auf, die einen zueinander passenden dreieckigen Querschnitt aufweisen. Bei axialem Verschieben des Schließkeils in der Basis schiebt er sich zugleich nach oben, so dass die Gesamthöhe der gemeinsamen Anordnung sich vergrößert.

Es ist daher Aufgabe der Erfindung, die Montage eines elektrischen Bauteils zu verbessern.

Diese Aufgabe wird durch ein Verfahren zum Montieren eines elektrischen Bauteils auf einem Sockelteil nach Anspruch 1 sowie eine elektrische Vorrichtung nach Anspruch 10 gelöst. Das Sockelteil 10 hat eine schräge Auflagefläche, und darauf wird ein Keilelement mit einer ersten Keilfläche angeordnet. Auf dieses Keilelement wird nun eine seitliche Kraft ausgeübt. Die Kraft wirkt von der Schmalseite des Keilelements her, so dass eine Kraftkomponente das Keilelement sich auf der Auflagefläche nach oben bewegen lässt, bis eine der ersten Keilfläche gegenüberliegende zweite Keilfläche des Keilelements eine gewünschte Position erreicht. Das elektrische Bauteil wird auf der zweiten Keilfläche angeordnet. Anschaulich ausgedrückt bewegt sich das Keilelement so lange auf der Schräge, bis seine Oberseite auf einer gewünschten Höhe für den Kontakt mit der elektrischen Komponente liegt. Dazu entspricht vorzugsweise der Keilwinkel des Keilelements gerade dem Winkel der schrägen Auflagefläche, damit die zweite Keilfläche horizontal orientiert ist.

Die Erfindung geht von dem Grundgedanken aus, den Toleranzausgleich über das Keilelement nur einmal während der Montage vorzunehmen und dann die erreichte Position festzuhalten. Dazu wird das Keilelement, wenn die zweite Keilfläche die gewünschte Position erreicht hat, mit mindestens einem ersten Befestigungselement an dem Sockelteil fixiert, insbesondere mit einer oder mehreren Schrauben. Anschließend wird die seitliche Kraft nicht mehr ausgeübt. Das Keilelement wird durch das erste Befestigungselement in der gewünschten Lage gehalten, Mittel zur seitlichen Krafteinwirkung mit Auffinden einer gewünschten Position sind deshalb nur während des Zusammenbaus erforderlich, danach nicht mehr.

Die Erfindung hat den Vorteil, dass mechanische Toleranzen zur verbesserten thermischen Anbindung des elektrischen Bauteils auf einfache Weise ausgeglichen werden. Es ist weder erforderlich, zum Toleranzausgleich dicke Wärmeleitpads mit schlechtem thermischem Leitwert einzusetzen, noch individuell für jedes Gerät ein Wärmeleitblech spezifischer Dicke auszuwählen und einzulegen. Der Wärmefluss über das eine Keilelement ist gut, und die Fixierung ist mit einfachsten Befestigungsmitteln wie Schrauben langzeitstabil.

Das elektrische Bauteil weist bevorzugt eine Leiterplatte auf. Die Leiterplatte ist mit einem oder mehreren elektrischen Bauteilen bestückt, deren Wärme abgeführt werden soll. Die auszugleichenden mechanischen Toleranzen treten beispielsweise durch das Stapeln von Leiterplatten auf.

Das Sockelteil ist bevorzugt als Gehäuseteil ausgebildet. Damit kann es die Wärme direkt nach außen ableiten. Alternativ ist das Sockelteil vorzugsweise zumindest thermisch an ein Gehäuseteil angebunden.

Das Keilelement weist wärmeleitendes Material auf. Das Sockelteil weist bevorzugt wärmeleitendes Material auf. Dazu sind sie insbesondere aus Metall hergestellt. Es entsteht eine gute Wärmebrücke von dem elektrischen Bauteil nach außen.

Das Keilelement liegt bevorzugt direkt auf dem Sockelteil auf. Es befinden sich also keine weiteren Bauteile dazwischen, insbesondere kein herkömmlich zum Ausgleich von Toleranzen vorzusehendes Wärmeleitpad. Das ist nicht erforderlich, weil das Keilelement dessen Aufgabe durch Einnehmen der gewünschten Position bereits erfüllt.

Vorzugsweise wird wärmeleitendes Material zwischen dem elektrischen Bauteil und der zweiten Keilfläche angeordnet. Während die erste Keilfläche auf dem Sockelteil fixiert und auf diese Weise eine dichte Anbindung sichergestellt ist, kann wärmeleitendes Material an der Schnittstelle zwischen Keil und elektrischem Bauteil helfen, weitere Toleranzen auszugleichen, die thermische Anbindung nochmals zu verbessern und mechanische Belastungen des möglicherweise empfindlichen elektrischen Bauteils zu vermeiden. Dabei geht es aber nur noch um kleine Toleranzen und daher eine dünne Schicht des wärmeleitenden Materials, da der größere Anteil bereits durch den Keil ausgeglichen ist.

Das erste Befestigungselement bildet vorzugsweise eine zu der Auflagefläche und der ersten Keilfläche senkrechte Verbindung. Es wird also für eine direkte, senkrechte Verbindung und Krafteinwirkung zwischen Keilelement und Sockelteil mit entsprechend gutem thermischem Übergang gesorgt. Das könnte die seitliche Kraft nicht leisten, sie hat nur eine Teilkomponente in dieser während der Lebenszeit des montierten Geräts wesentlichen Richtung. Eine einfache Realisierungsmöglichkeit ist ein selbst senkrecht orientiertes erstes Befestigungselement, insbesondere ein senkrechtes Verschrauben. Eine gewisse Schräglage beispielsweise zur besseren Zugänglichkeit mit einem Werkzeug ist aber noch möglich.

Das elektrische Bauteil wird bevorzugt auf dem Sockelteil angeordnet, um während des Ausübens der seitlichen Kraft die gewünschte Position vorzugeben. Auf diese Weise gibt das elektrische Bauteil selbst, das in seine Zielposition gebracht wird, die gewünschte Position des Keilelements vor. Die seitliche Kraft drückt es unter Ausgleich der Toleranzen mit der zweiten Keilfläche nach oben bis an die Unterseite des elektrischen Bauteils oder, falls gewünscht, eines dazwischen noch angeordneten Wärmeleitmaterials. In dieser Position wird dann das Keilelement an dem Sockelteil fixiert. Vorzugsweise weist das elektrische Bauteil mindestens eine Öffnung auf, durch die hindurch das erste Befestigungselement fixiert wird. Alternativ kann das Keilelement seitliche Befestigungsbereiche aufweisen, die für ein Werkzeug zum Fixieren des ersten Befestigungselements zugänglich bleiben.

Vorzugsweise wird zunächst vor dem elektrischen Bauteil eine Schablone mit einer Geometrie entsprechend dem elektrischen Bauteil auf dem Sockelteil angeordnet, um während des Ausübens der seitlichen Kraft die gewünschte Position vorzugeben. Der Schablone schaden gewisse mechanische Belastungen während des Toleranzausgleichs mit der seitlichen Kraft und der Fixierung des Keilelements nicht, die ein elektrisches Bauteil wie eine bestückte Leiterplatte beeinträchtigen könnten. Außerdem kann die Schablone so ausgelegt sein, dass es einen einfachen Zugang für das Fixieren des ersten Befestigungselements gibt. Die Übereinstimmung der Geometrie der Schablone mit derjenigen des elektrischen Bauteils betrifft nur die Bereiche, die für die Auflage auf der zweiten Keilfläche und die Befestigung auf dem Sockelteil relevant sind, so dass ansonsten Freiheit besteht, Öffnungen und dergleichen für den Werkzeugzugang vorzusehen.

Die Schablone wird dann vorzugsweise entfernt, wenn das Keilelement mit dem ersten Befestigungselement an dem Sockelteil fixiert ist. Statt der Schablone wird das elektrische Bauteil mit mindestens einem zweiten Befestigungselement an dem Sockelteil fixiert, insbesondere verschraubt. Im Falle einer Leiterplatte liegen nun die bestückten elektrischen Komponenten auf der zweiten Keilfläche auf, wie dies mit der Schablone ausgemessen wurde, und so wird deren Abwärme durch das Keilelement in das Sockelteil und weiter nach außen abgeführt. Die Schablone kann einen definierten Abstand für ein Wärmeleitpad oder dergleichen zwischen dem elektrischen Bauteil und dem zweiten Keilelement berücksichtigen.

In bevorzugter Weiterbildung wird ein Verfahren zur Herstellung eines Sensors angegeben, bei dem mit einer der Ausführungsformen des erfindungsgemäßen Verfahrens mindestens ein elektrisches Bauteil auf mindestens einem Sockelteil montiert wird. Der Sensor ist bevorzugt ein optoelektronischer Sensor, insbesondere eine Kamera, die als Codeleser ausgebildet sein kann. Das elektrische Bauteil kann eine Leiterplatte mit einer Lichtquelle, einem Lichtempfänger oder Bildsensor und sonstigen elektronischen Komponenten für Datenaustausch, Versorgung oder Steuer- beziehungsweise Auswertungsfunktionen sein.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Schnittdarstellung eines Sockelteils mit schräger Auflagefläche;
- Fig. 2: eine Schnittdarstellung des Sockelteils mit aufgelegter Schablone eines elektrischen Bauteils;
- Fig. 3: eine Schnittdarstellung, bei der ein Metallkeil zwischen Sockelteil und Schablone eingeführt und mit einer seitlichen Kraft angedrückt wird;
- Fig. 4: eine Schnittdarstellung, in welcher der Metallkeil in einer Zielposition fixiert wird;
- Fig. 5: eine Schnittdarstellung, bei der nach der Fixierung die seitliche Kraft nicht mehr ausgeübt und die Schablone entfernt wird; und
- Fig. 6: eine Schnittdarstellung, in der das elektrisches Bauteil anstelle der Schablone aufgelegt und an dem Sockelteil befestigt wird.

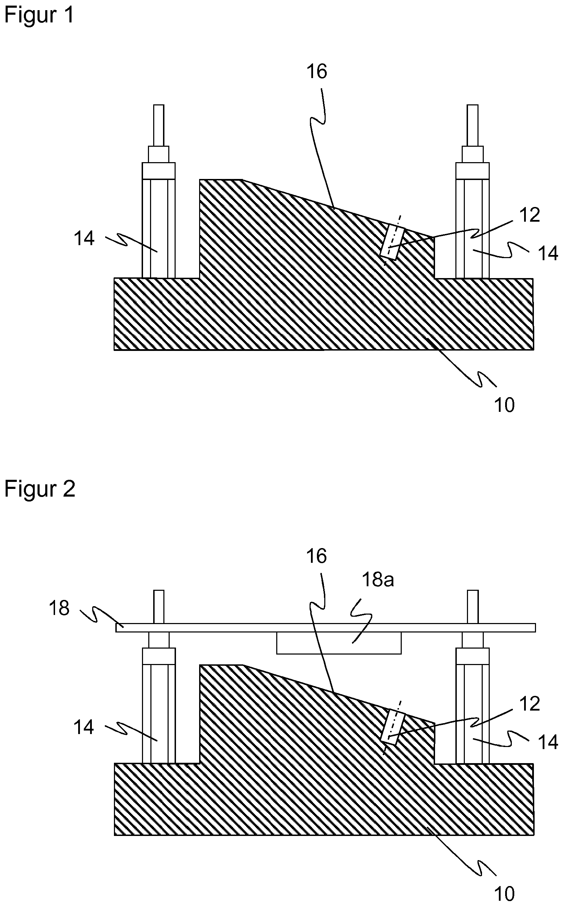

Figur 1 zeigt eine Schnittdarstellung eines Sockelteils 10 einer elektrischen Vorrichtung, insbesondere eines Sensors. Das Sockelteil 10 ist vorzugsweise ein Gehäuseteil aus Metall oder anderem wärmeleitfähigen Material, alternativ thermisch mit einem Gehäuse oder einer anderen Wärmesenke verbunden. Auf dem Sockelteil 10 soll ein elektrisches Bauteil montiert und durch gute Wärmeanbindung gekühlt werden, beispielsweise eine bestückte Leiterplatte mit Komponenten wie einem FPGA, einem Mikroprozessor, einer Lichtquelle oder einem Lichtempfänger, etwa wie eine oder mehrere Photodioden oder APDs (Avalanche Photodiode) oder ein Bildsensor.

Das Sockelteil 10 hat eine Öffnung 12 für ein erstes Befestigungselement, wobei je nach Abmessungen auch mehrere Öffnungen 12 für mehrere erste Befestigungselemente möglich sind. Ferner sind zweite Befestigungselemente 14 für das elektrische Bauteil vorgesehen. Auf der Oberseite, wo das elektrische Bauteil montiert wird, weist das Sockelteil 10 eine schräge Auflagefläche 16 auf. Bei glatter, horizontaler Oberseite würde das elektrische Bauteil darauf nur mit großer mechanischer Toleranz montiert, die erfindungsgemäß durch die schräge Auflagefläche 16 und die weiteren, nachfolgend unter Bezugnahme auf die Figuren 2 bis 6 erläuterten Schritte zur Montage des elektrischen Bauteils vermieden wird.

Figur 2 zeigt eine weitere Schnittdarstellung des Sockelteils 10, in der eine Schablone 18 auf das Sockelteil 10 aufgelegt wird. Dazu werden hier die zweiten Befestigungselemente 14 genutzt, aber die Schablone 18 könnte auch anders in ihre Zielposition gebracht werden. Die Schablone 18 weist zumindest in den späteren Auflage- und Befestigungsbereichen dieselbe Geometrie auf wie das zu montierende elektrische Bauteil, in diesem Beispiel eine bestückte Leiterplatte. Die auf der Leiterplatte befindlichen elektronischen Komponenten werden auf der Schablone 18 durch einen Materialblock 18a repräsentiert, welcher die Abmessungen der elektronischen Komponenten und möglicherweise zusätzlich eines darauf anzuordnenden Wärmeleitmaterials hat.

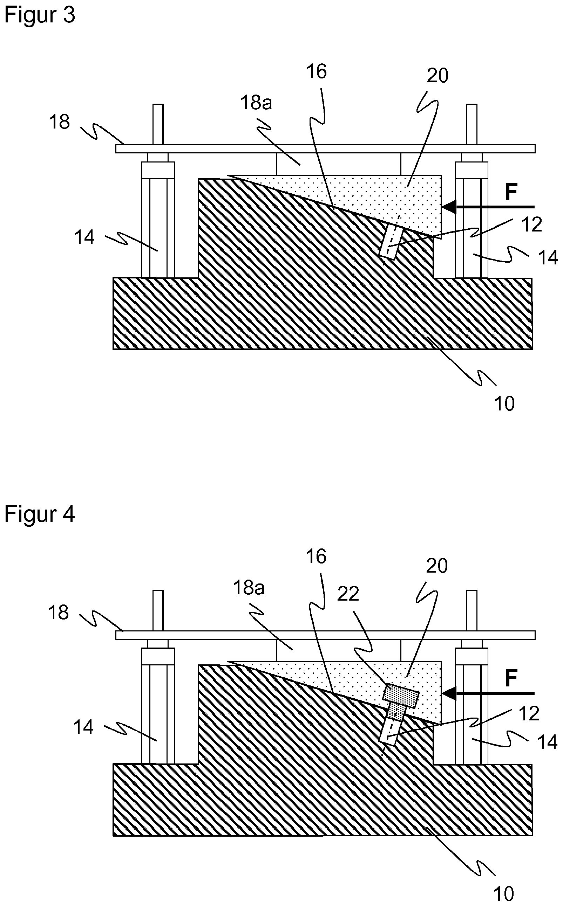

Figur 3 zeigt eine weitere Schnittansicht, in der nun ein Keilelement 20 aus Metall oder einem anderen wärmeleitenden Material seitlich so eingeführt wird, dass es mit seiner unteren Fläche auf der schrägen Auflagefläche 16 aufliegt. Von der Schmalseite des Keilelements 20 her wird eine definierte seitliche Kraft F ausgeübt, durch die sich das Keilelement 20 so weit in den Zwischenraum bewegt, bis die untere Fläche des Keilelements 20 weiterhin an die schräge Auflagefläche 16 und die obere Fläche des Keilelements 20 an die Schablone 18 beziehungsweise den Materialblock 18a angedrückt ist. Die Schablone 18 gibt somit die gewünschte Position des Keilelements 20 und insbesondere die Höhe von dessen oberer Fläche vor, bei der ein Aufliegen unter Toleranzausgleich erreicht ist.

Figur 4 zeigt eine weitere Schnittansicht, in welcher das Keilelement 20 mit einem ersten Befestigungselement 22 an dem Sockelteil 10 fixiert wird. In diesem Beispiel ist das erste Befestigungselement 22 eine Schraube, die in die Öffnung 12 eingeschraubt wird. Die Schablone 18 kann so ausgelegt sein, dass ein Werkzeugzugang für die Fixierung des ersten Befestigungselements 22 erleichtert ist, beispielsweise durch entsprechende Öffnungen und Aussparungen, welche das elektrische Bauteil möglichweise nicht aufweist. Durch die direkte, senkrechte Krafteinwirkung des ersten Befestigungselements 22 ist ein idealer thermischer Übergang zwischen Sockelteil 10 und Keilelement 20 hergestellt. Das feste Andrücken an den Kontaktflächen macht auch ein an sich denkbares Wärmematerial zwischen Sockelteil 10 und Keilelement 20 entbehrlich.

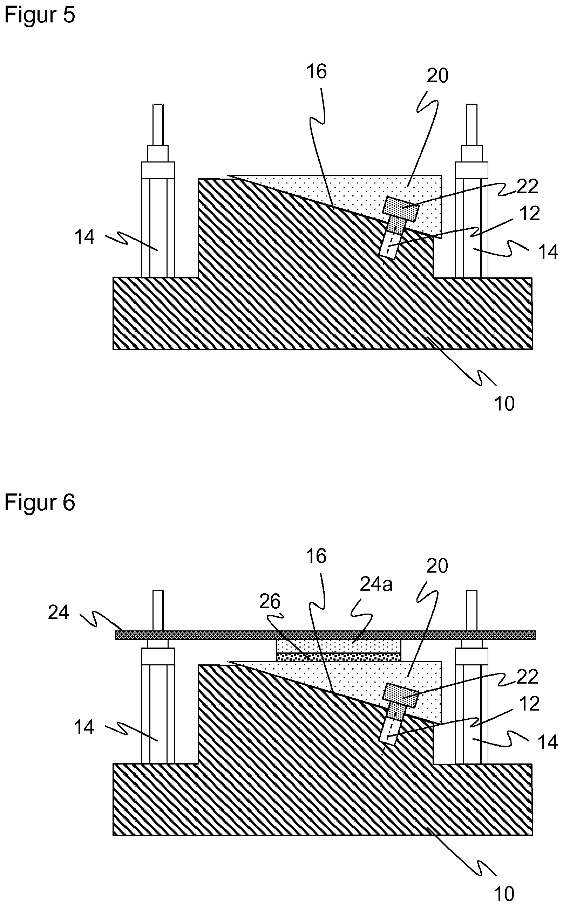

Figur 5 zeigt eine Schnittansicht, in dem nach Fixierung des Keilelements 20 an dem Sockelteil 10 in der gewünschten Position zum Toleranzausgleich die Schablone 18 wieder entfernt ist. Außerdem ist nun das Einwirken der seitlichen Kraft nicht länger erforderlich.

Figur 6 zeigt eine Schnittansicht, in der das elektrische Bauteil 24, in diesem Fall eine mit einer elektronischen Komponente 24a bestückte Leiterplatte, die mit der Schablone 18 festgelegte Position einnimmt. Das elektrische Bauteil 24 wird mit Hilfe der zweiten Befestigungselemente 14 an dem Sockelteil 10 fixiert, insbesondere verschraubt.

Zwischen dem elektrischen Bauteil 24 und dem Keilelement 20 ist vorzugsweise noch wärmeleitendes Material 26 angeordnet, beispielsweise ein Temperaturpad oder eine Wärmeleitpaste oder beides, wie eine Polyimid-Folie mit Paste. Damit können verbleibende Toleranzen des elektrischen Bauteils 24 beziehungsweise der Leiterplatte und deren Bestückung ausgeglichen werden. Eine typische Ausdehnung des wärmeleitenden Materials 26 kann in dem Materialblock 18a der Schablone 18 berücksichtigt sein.

Alternativ zu einer Höhenanpassung mittels Schablone 18 kann auch im zu Figur 2 beschriebenen Schritt direkt das elektrische Bauteil 24 auf das Sockelteil 10 aufgelegt werden. Dann muss es aber eine Möglichkeit geben, das Keilelement 20 bei aufliegendem elektrischem Bauteil 24 mit dem ersten Befestigungselement 22 auf dem Sockelteil 10 zu fixieren. Die Zugänglichkeit kann beispielsweise durch Öffnungen in dem elektrischen Bauteil 24 beziehungsweise der Leiterplatte, durch einen Überstand des Keilelements 20 mit den Öffnungen 12 oder über eine seitliche Umlenkmechanik geschaffen werden. Die zu den Figuren 5 und 6 beschriebenen Schritte entfallen in dieser alternativen Ausführungsform, es kann einfach im Zustand gemäß Figur 4, allerdings mit der Schablone 18 durch das elektrische Bauteil 24 ersetzt, das Ausüben der seitlichen Kraft F eingestellt werden.

## Patentansprüche

1. Verfahren zum Montieren eines elektrischen Bauteils (24) auf einem Sockelteil (10) mit einer schrägen Auflagefläche (16) mit Ausgleich mechanischer Toleranzen zur verbesserten thermischen Anbindung des Bauteils (24), bei dem ein Keilelement (20) aus Metall oder einem anderen wärmeleitenden Material mit einer ersten Keilfläche auf der Auflagefläche (16) angeordnet wird und von der Schmalseite des Keilelements (20) her eine seitliche Kraft (F) auf das Keilelement (20) ausgeübt wird, so dass sich die erste Keilfläche auf der Auflagefläche (16) bewegt, bis eine von der Auflagefläche (16) abgewandte zweite Keilfläche des Keilelements (20) eine gewünschte Position erreicht, und wobei das elektrische Bauteil (24) auf der zweiten Keilfläche angeordnet wird,
**dadurch gekennzeichnet,**
**dass** das Keilelement (20) mit einem ersten Befestigungselement (22), insbesondere einer Schraube, an dem Sockelteil (10) fixiert und in der gewünschten Lage gehalten wird und danach die seitliche Kraft (F) von der Schmalseite des Keilelements (20) her nicht mehr ausgeübt wird, somit Mittel zur seitlichen Krafteinwirkung mit Auffinden einer gewünschten Position nur während des Montierens erforderlich sind, danach nicht mehr.

2. Verfahren nach Anspruch 1,
wobei das elektrische Bauteil (24) eine Leiterplatte aufweist und/oder wobei das Sockelteil (10) als Gehäuseteil ausgebildet ist.

3. Verfahren nach Anspruch 1 oder 2,
wobei das Keilelement (20) und/oder das Sockelteil (10) wärmeleitendes Material aufweisen.

4. Verfahren nach einem der vorhergehenden Ansprüche,
wobei das Keilelement (20) direkt auf dem Sockelteil (10) aufliegt.

5. Verfahren nach einem der vorhergehenden Ansprüche,
wobei wärmeleitendes Material (26) zwischen dem elektrischen Bauteil (24) und der zweiten Keilfläche angeordnet wird.

6. Verfahren nach einem der vorhergehenden Ansprüche,
wobei das erste Befestigungselement (22) zu der Auflagefläche (16) und der ersten Keilfläche senkrechtorientiert ist.

7. Verfahren nach einem der vorhergehenden Ansprüche,
wobei das elektrische Bauteil (24) auf dem Sockelteil (10) angeordnet wird, um während des Ausübens der seitlichen Kraft (F) die gewünschte Position vorzugeben.

8. Verfahren nach einem der Ansprüche 1 bis 6,
wobei zunächst vor dem elektrischen Bauteil (24) eine Schablone (18) mit einer Geometrie entsprechend dem elektrischen Bauteil (24) auf dem Sockelteil (10) angeordnet wird, um während des Ausübens der seitlichen Kraft (F) die gewünschte Position vorzugeben, und wobei insbesondere die Schablone (18) entfernt wird, wenn das Keilelement (20) mit dem ersten Befestigungselement (22) an dem Sockelteil (10) fixiert ist.

9. Verfahren zur Herstellung eines Sensors, bei dem mit einem Verfahren nach einem der vorhergehenden Ansprüche mindestens ein elektrisches Bauteil (24) auf mindestens einem Sockelteil (10) montiert wird.

## Claims

1. A method of mounting an electrical component (24) on a base part (10) having an inclined support surface (16) for a compensation of mechanical tolerances and an improved thermal connection of the component (24), wherein a first wedge surface of a wedge element (20) made of metal or another thermally conductive material is arranged on the support surface (16), and a lateral force (F) is exerted on the wedge element (20) from the narrow side of the wedge element (20), so that the first wedge surface moves on the support surface (16) until a second wedge surface of the wedge element (20) remote from the support surface (16) reaches a desired position, and wherein the electrical component (24) is arranged on the second wedge surface,
**characterized in that** the wedge element (20) is fixed to the base part (10) and held in the desired position using a first fastening element (22), in particular a screw, and the lateral force (F) from the narrow side of the wedge element (20) is afterwards no longer exerted, thus means for exerting the lateral force and reaching the desired position are only necessary during assembly and then no longer.

2. The method in accordance with claim 1,
wherein the electrical component (24) has a circuit board and/or the base part (10) is configured as a housing part.

3. The method in accordance with claim 1 or 2,
wherein the wedge element (20) and/or the base part (10) comprises thermally conductive material.

4. The method in accordance with any of the preceding claims,
wherein the wedge element (20) lies directly on the base part (10).

5. The method in accordance with any of the preceding claims,
wherein thermally conductive material (26) is arranged between the electrical component (24) and the second wedge surface.

6. The method in accordance with any of the preceding claims,
wherein the first fastening element (22) is oriented perpendicular to the support surface (16) and the first wedge surface.

7. The method in accordance with any of the preceding claims,
wherein the electrical component (24) is arranged on the base part (10) to predefine the desired position during the exertion of the lateral force (F).

8. The method in accordance with any of the preceding claims,
wherein a template (18) having a geometry corresponding to the electrical component (24) is arranged before the electrical component (24) on the base part (10) to predefine the desired position during the exertion of the lateral force (F), and wherein in particular the template (18) is removed once the wedge element (20) is fixed to the base part (10) using the first fastening element (20).

9. A method of manufacturing a sensor, wherein at least one electrical component (24) is mounted on at least one base part (10) using a method according to any of the preceding claims.

## Revendications

1. Procédé de montage d'un composant électrique (24) sur une partie de base (10) ayant une surface d'appui (16) inclinée avec compensation des tolérances mécaniques en vue d'une meilleure liaison thermique du composant (24), dans lequel un élément formant cale (20) en métal ou en un autre matériau conducteur de chaleur est disposé avec une première surface de cale sur la surface d'appui (16), et une force latérale (F) est appliquée à l'élément formant cale (20) depuis le petit côté de l'élément formant cale (20), de sorte que la première surface de cale se déplace sur la surface d'appui (16) jusqu'à ce qu'une deuxième surface de cale de l'élément formant cale (20), détournée de la surface d'appui (16), atteigne une position souhaitée, et le composant électrique (24) est disposé sur la deuxième surface de cale,
**caractérisé en ce que**
l'élément formant cale (20) est fixé à la partie de base (10) et maintenu dans la position souhaitée par un premier élément de fixation (22), en particulier par une vis, et ensuite la force latérale (F) n'est plus appliquée depuis le petit côté de l'élément formant cale (20), et donc des moyens pour l'application de la force latérale en vue de trouver une position souhaitée ne sont nécessaires que lors du montage, ensuite ils ne sont plus nécessaires.

2. Procédé selon la revendication 1, dans lequel le composant électrique (24) comporte une carte de circuit imprimé, et/ou la partie de base (10) est réalisée sous forme de partie de boîtier.

3. Procédé selon la revendication 1 ou 2, dans lequel l'élément formant cale (20) et/ou la partie de base (10) présente(nt) un matériau conducteur de chaleur.

4. Procédé selon l'une des revendications précédentes, dans lequel l'élément formant cale (20) repose directement sur la partie de base (10).

5. Procédé selon l'une des revendications précédentes, dans lequel un matériau conducteur de chaleur (26) est disposé entre le composant électrique (24) et la deuxième surface de cale.

6. Procédé selon l'une des revendications précédentes, dans lequel le premier élément de fixation (22) est orienté perpendiculairement à la surface d'appui (16) et à la première surface de cale.

7. Procédé selon l'une des revendications précédentes, dans lequel le composant électrique (24) est disposé sur la partie de base (10) afin d'imposer la position souhaitée lors de l'application de la force latérale (F).

8. Procédé selon l'une des revendications 1 à 6, dans lequel tout d'abord, devant le composant électrique (24), un gabarit (18) ayant une géométrie correspondant au composant électrique (24) est disposé sur la partie de base (10), afin d'imposer la position souhaitée lors de l'application de la force latérale (F), et en particulier, le gabarit (18) est enlevé lorsque l'élément formant cale (20) est fixé sur la partie de base (10) par le premier élément de fixation (22).

9. Procédé de réalisation d'un capteur, dans lequel au moins un composant électrique (24) est monté sur au moins une partie de base (10) par un procédé selon l'une des revendications précédentes.
